(19) Europäisches Patentamt

European Patent Office

Office européen des brevets

(11) **EP 4 675 293 A1**

(12) **EUROPEAN PATENT APPLICATION**
published in accordance with Art. 153(4) EPC

(43) Date of publication:
**07.01.2026 Bulletin 2026/02**

(21) Application number: **24860386.2**

(22) Date of filing: **27.08.2024**

(51) International Patent Classification (IPC):
$G01R\ 31/392^{(2019.01)}$   $G01R\ 31/396^{(2019.01)}$
$G01R\ 31/367^{(2019.01)}$   $G01R\ 31/385^{(2019.01)}$
$G01R\ 31/382^{(2019.01)}$   $G01R\ 19/165^{(2006.01)}$
$B60L\ 58/16^{(2019.01)}$

(52) Cooperative Patent Classification (CPC):
**B60L 58/16; G01R 19/165; G01R 31/36;
G01R 31/367; G01R 31/382; G01R 31/385;
G01R 31/392; G01R 31/396**

(86) International application number:
**PCT/KR2024/012804**

(87) International publication number:
**WO 2025/048466 (06.03.2025 Gazette 2025/10)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.08.2023 KR 20230115868**

(71) Applicant: **LG ENERGY SOLUTION, LTD.
Seoul 07335 (KR)**

(72) Inventors:
• **KIM, Ji-Yeon
  Daejeon 34122 (KR)**
• **KIM, Young-Deok
  Daejeon 34122 (KR)**
• **PARK, Jun-Cheol
  Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **APPARATUS AND METHOD FOR ESTIMATING SOH**

(57)    An apparatus for estimating a SOH according to one aspect of the present disclosure may include a profile obtaining unit configured to obtain an OCV profile for a plurality of OCVs of a battery measured at different time points; a profile correcting unit configured to generate an adjusted positive electrode profile and an adjusted negative electrode profile by adjusting a preset criterion positive electrode profile and a preset criterion negative electrode profile to correspond to the OCV profile; and a control unit configured to extract at least one of a diagnosis factor related to the positive electrode participation finalizing point for the battery from the adjusted positive electrode profile and a diagnosis factor related to the positive electrode change rate for the battery from the criterion positive electrode profile and the adjusted positive electrode profile, and estimate a positive electrode SOH of the battery based on the extracted diagnosis factor.

FIG. 1

**Description**

TECHNICAL FIELD

This application is based on and claims priority from Korean Patent Application No. 10-2023-0115868, filed on August 31, 2023, with the Korean Intellectual Property Office, the disclosure of which is incorporated herein in its entirety by reference.

The present disclosure relates to an apparatus and method for estimating a SOH (State of health), and more specifically, to an apparatus and method for estimating a SOH, which estimates the SOH of a battery using an OCV (Open circuit voltage).

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

A lot of research is being conducted on these batteries in terms of high-capacity and high-density, but the aspect of improving lifespan and safety is also important. In order to improve the safety of the battery, technology to accurately diagnose the current state of the battery is required.

Conventionally, the state of the battery is diagnosed by analyzing the battery profile, which represents the correspondence relationship between capacity and voltage of the battery. For example, during the battery charging process, capacity and voltage are measured, and the battery state is diagnosed through analysis of the battery profile, which represents the correspondence relationship between the measured capacity and voltage. As another example, the state of the battery may be diagnosed based on the capacity and voltage measured during the battery discharge process.

Here, in order to more accurately diagnose the current state of the battery, a battery profile that accurately reflects the current state of the battery is required. However, in order to obtain this battery profile, there is a problem that low rate charging and discharging such as 0.05 C (C-rate) is required. That is, in the past, low-rate charging and discharging is required to diagnose the state of the battery, so there are limitations in diagnosing the state of the battery. For example, since it takes about 20 hours to fully charge the battery at 0.05 C, there is a problem that a considerable amount of time is required to diagnose the condition of the battery according to the conventional low-rate charging and discharging.

DISCLOSURE

Technical Problem

The present disclosure is designed to solve the problems of the related art, and therefore the present disclosure is directed to providing an apparatus and method for estimating a SOH, which estimates the SOH of a battery using an OCV.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

An apparatus for estimating a SOH according to one aspect of the present disclosure may comprise a profile obtaining unit configured to obtain an OCV profile for a plurality of OCVs of a battery measured at different time points; a profile correcting unit configured to generate an adjusted positive electrode profile and an adjusted negative electrode profile by adjusting a preset criterion positive electrode profile and a preset criterion negative electrode profile to correspond to the OCV profile; and a control unit configured to extract at least one of a diagnosis factor related to the positive electrode participation finalizing point for the battery from the adjusted positive electrode profile and a diagnosis factor related to the positive electrode change rate for the battery from the criterion positive electrode profile and the adjusted positive electrode profile, and estimate a positive electrode SOH of the battery based on the extracted diagnosis factor.

The plurality of OCVs may be configured to include an OCV measured at a time point when the battery transitions from an idle state to a discharge state and an OCV measured while a condition that a discharge current of the battery is equal to or less than a preset threshold current is maintained during a preset criterion time or more.

The plurality of OCVs may be configured to include a plurality of OCVs measured within a preset criterion period.

The criterion period may be set based on a preset target period, a period required to measure a preset number of OCVs, a period required to reduce the SOH of the battery by a preset criterion SOH, or a combination thereof.

The profile correcting unit may be configured to generate a comparison full-cell profile based on the criterion positive electrode profile and the criterion negative electrode profile, and generate the adjusted positive electrode profile and the adjusted negative electrode profile by adjusting the criterion positive electrode profile and the criterion negative electrode profile until the generated comparison full-cell profile corresponds to the OCV profile.

The profile correcting unit may be configured to determine a target capacity range corresponding to the OCV profile and compare the comparison full-cell profile and the OCV profile in the target capacity range.

The control unit may be configured to estimate a positive electrode SOH of the battery by comparing the value of the diagnosis factor with a criterion value preset for the diagnosis factor.

The control unit may be configured to adjust a usage condition for the battery based on the estimated positive electrode SOH.

A battery pack according to another aspect of the present disclosure may comprise the apparatus for estimating a SOH according to the present disclosure.

A vehicle according to still another aspect of the present disclosure may comprise the apparatus for estimating a SOH according to the present disclosure.

A server according to still another aspect of the present disclosure may comprise the apparatus for estimating a SOH according to the present disclosure.

A method for estimating a SOH according to still another aspect of the present disclosure may comprise a profile obtaining step of obtaining an OCV profile for a plurality of OCVs of a battery measured at different time points; a profile adjusting step of generating an adjusted positive electrode profile and an adjusted negative electrode profile by adjusting a preset criterion positive electrode profile and a preset criterion negative electrode profile to correspond to the OCV profile; a diagnosis factor extracting step of extracting at least one of a diagnosis factor related to the positive electrode participation finalizing point for the battery from the adjusted positive electrode profile and a diagnosis factor related to the positive electrode change rate for the battery from the criterion positive electrode profile and the adjusted positive electrode profile; and a SOH estimating step of estimating a positive electrode SOH of the battery based on the extracted diagnosis factor.

Advantageous Effects

According to one aspect of the present disclosure, the present disclosure has an advantage of quickly estimating the SOH of the battery based on the OCV profile without restricting the use of the battery.

In addition, according to one aspect of the present disclosure, the apparatus for estimating a SOH has an advantage of diagnosing the state of the battery from various perspectives, based on the type of diagnosis factor that may be extracted.

The effects of the present disclosure are not limited to the effects mentioned above, and other effects not mentioned will be clearly understood by those skilled in the art from the description of the claims.

DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing an apparatus for estimating a SOH according to an embodiment of the present disclosure.

FIG. 2 is a diagram schematically showing an OCV profile according to an embodiment of the present disclosure.

FIG. 3 is a diagram showing a measured OCV of the battery according to an embodiment of the present disclosure.

FIG. 4 is a diagram schematically showing a criterion positive electrode profile and a criterion negative electrode profile according to an embodiment of the present disclosure.

FIG. 5 is a diagram schematically showing a comparison full-cell profile according to an embodiment of the present disclosure.

FIG. 6 is a diagram schematically showing a comparison full-cell profile and an OCV profile according to an embodiment of the present disclosure.

FIGS. 7 to 14 are diagrams for explaining the process of adjusting a criterion positive electrode profile and a criterion negative electrode profile according to an embodiment of the present disclosure.

FIG. 15 is a diagram schematically showing an exemplary configuration of a battery pack according to another embodiment of the present disclosure.

FIG. 16 is a diagram schematically showing an exemplary configuration of a vehicle according to still another embodiment of the present disclosure.

FIG. 17 is a diagram schematically showing a method for estimating a SOH according to still another embodiment of the present disclosure.

BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

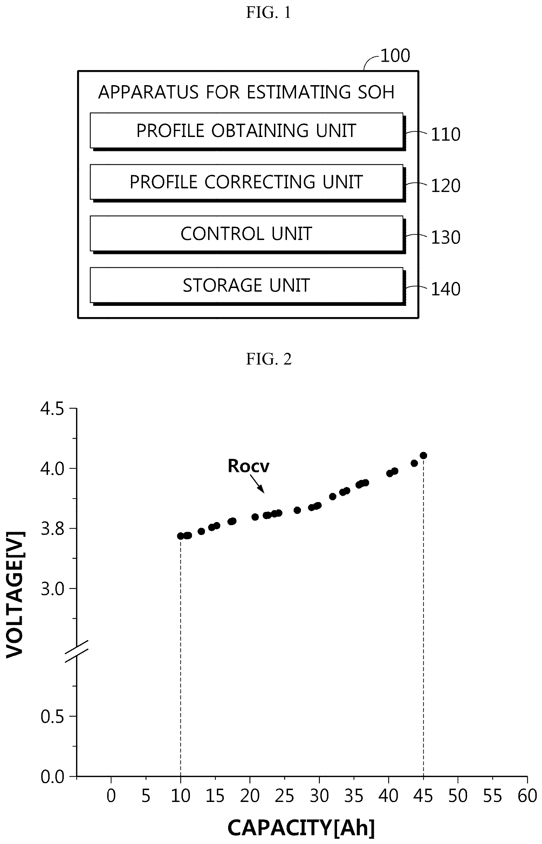

FIG. 1 is a diagram schematically showing an apparatus 100 for estimating a SOH (State of health) according to an embodiment of the present disclosure.

Referring to FIG. 1, the apparatus 100 for estimating a SOH may include a profile obtaining unit 110, a profile correcting unit 120, and a control unit 130.

The profile obtaining unit 110 may be configured to obtain an OCV profile Rocv for a plurality of OCVs (Open circuit voltages) of a battery measured at different time points.

Here, the battery refers to an independent cell that has a negative terminal and a positive terminal and is physically separable. As an example, a lithium-ion battery or a lithium polymer battery may be considered as a battery. Additionally, the type of battery may be a cylindrical type, a prismatic type, or a pouch type. Additionally, the battery may mean a battery bank, a battery module or a battery pack in which a plurality of cells are connected in series and/or parallel. Below, for convenience of explanation, the battery is explained as meaning one independent cell.

Here, the OCV profile Rocv is a profile that represents the correspondence relationship between the OCV and capacity of the battery. Specifically, the OCV of a battery may be measured at a time point that satisfies a predetermined condition. More specifically, the plurality of OCVs may be configured to include OCV measured at the time point when the battery transitions from the idle state to the discharge state and OCV measured while the condition that the discharge current of the battery is equal to or less than a preset threshold current is maintained for a preset criterion time or more.

First, the OCV of the battery may be measured at the time point when the battery transitions from the idle state to the discharge state. Here, the idle state refers to a stabilized state in which the battery is maintained in an unloaded state for a certain period of time or more. For example, when a battery is included in a vehicle, the OCV of the battery may be measured at the key-on time point when the engine of the vehicle that has been parked for a certain period of time is turned on. Also, the capacity of the battery may be determined according to the capacity at the key-off time point when the engine of the vehicle is turned off.

Next, the OCV of the battery may be measured while the condition that the discharge current of the battery is equal to or less than the preset threshold current is maintained for the preset criterion time or more. Here, the state in which the discharge current of the battery is equal to or less than the threshold current means a state in which the discharge amount of the battery may be ignored. In other words, when the battery is being discharged but the amount of discharge is minimal, the measured voltage of the battery may be estimated as OCV. This is because, if the discharge amount of the battery is negligible, the battery may be considered to be in a stable state even if the battery is being discharged beyond the criterion time. For example, when a battery is included in a vehicle and the vehicle is stopped for a criterion time or more, the battery may be continuously discharged to supply power to electrical components. However, the discharge amount of the battery to supply power to electronic components is very small based on the capacity of the battery. Therefore, although the battery is actually in a discharged state, the voltage of the battery may be estimated as OCV.

FIG. 2 is a diagram schematically showing an OCV profile Rocv according to an embodiment of the present disclosure. Referring to FIG. 2, the OCV profile Rocv represents the correspondence relationship between the OCV and capacity of the battery in a capacity range of 10 (Ah) to 45 (Ah). As explained previously, the conditions under which OCV may be measured are limited, so the plurality of OCVs included in the OCV profile Rocv may be discontinuous.

For example, the profile obtaining unit 110 may directly receive the OCV profile Rocv from the outside. That is, the profile obtaining unit 110 may obtain the OCV profile Rocv by receiving the OCV profile Rocv by being connected to the outside wired and/or wirelessly.

As another example, the profile obtaining unit 110 may receive battery information about the OCV (V) and capacity (Q) of the battery. Additionally, the profile obtaining unit 110 may generate an OCV profile Rocv based on the received battery information. That is, the profile obtaining unit 110 may obtain the OCV profile Rocv by directly generating the OCV profile Rocv based on battery information.

The profile obtaining unit 110 may be connected to enable communication with the profile correcting unit 120. For example, the profile obtaining unit 110 may be connected to the profile correcting unit 120 wired and/or wirelessly. The profile obtaining unit may transmit the obtained OCV profile Rocv to the profile correcting unit 120.

The profile correcting unit 120 may be configured to generate an adjusted positive electrode profile and an adjusted negative electrode profile by adjusting a preset criterion positive electrode profile Rp and a preset criterion negative electrode profile Rn to correspond to the OCV profile Rocv.

The criterion positive electrode profile Rp may be a profile representing a correspondence relationship between the capacity and OCV of a criterion positive electrode cell preset to correspond to the positive electrode of the battery. For example, the criterion positive electrode cell may be a positive electrode coin half-cell or a positive electrode of a three-electrode cell. Additionally, the criterion negative electrode profile Rn may be a profile representing a correspondence relationship between the capacity and OCV of a criterion negative electrode cell preset to correspond to the negative electrode of the battery. For example, the criterion negative electrode cell may be a negative electrode coin half-cell or a negative electrode of a three-electrode cell.

Specifically, the profile correcting unit 120 may adjust the criterion positive electrode profile Rp and the criterion negative electrode profile Rn to correspond to the OCV profile Rocv. More specifically, the profile correcting unit 120 may adjust the criterion positive electrode profile Rp and the criterion negative electrode profile Rn to generate an adjusted positive electrode profile and an adjusted negative electrode profile. Additionally, the profile correcting unit 120 may generate a comparison full-cell profile S from the adjusted positive electrode profile and the adjusted negative electrode profile. The profile correcting unit 120 may adjust the criterion positive electrode profile Rp and the criterion negative electrode profile Rn until the comparison full-cell profile S corresponds to the OCV profile Rocv. Here, the target capacity range T of the OCV profile Rocv may be different from the capacity range of the comparison full-cell profile S. Therefore, the criterion positive electrode profile Rp and the criterion negative electrode profile Rn may be adjusted depending on the correspondence between the comparison full-cell profile S and the OCV profile Rocv in the target capacity range T.

For example, the profile correcting unit 120 may generate a plurality of comparison full-cell profiles S by shifting the criterion positive electrode profile Rp and the criterion negative electrode profile Rn or scaling the capacities thereof, and specify a comparison full-cell profile S with the minimum error with the OCV profile Rocv among the plurality of comparison full-cell profiles S. Also, an adjusted positive electrode profile and an adjusted negative electrode profile corresponding to the specified comparison full-cell profile S may be determined.

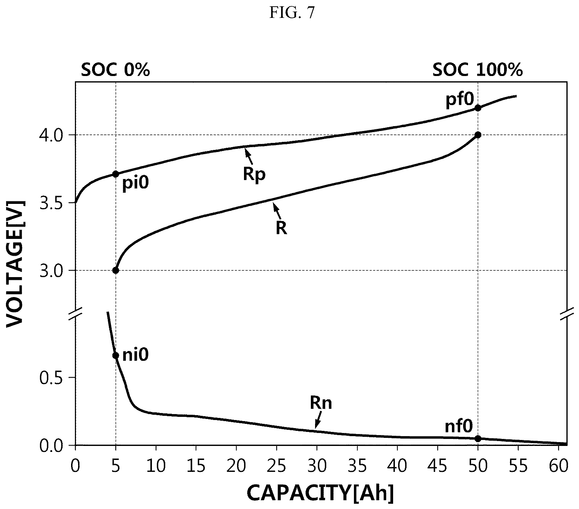

In relation to this, a more specific embodiment in which the profile correcting unit 120 determines the positive electrode profile of the battery by adjusting the criterion positive electrode profile Rp and the criterion negative electrode profile Rn to correspond to the OCV profile Rocv will be described later with reference to FIGS. 7 to 14.

The control unit 130 may be configured to extract at least one of a diagnosis factor related to the positive electrode participation finalizing point for the battery from the adjusted positive electrode profile and a diagnosis factor related to the positive electrode change rate for the battery from the criterion positive electrode profile and the adjusted positive electrode profile.

For example, the control unit 130 may determine the positive electrode participation finalizing point in the adjusted positive electrode profile. Also, the control unit 130 may determine a potential value or SOC value corresponding to the positive electrode participation finalizing point pf in the adjusted positive electrode profile as the value of the positive electrode participation finalizing point pf.

As another example, the control unit 130 may determine the positive electrode change rate ps that is a change rate [%] of the adjusted positive electrode profile with respect to the criterion positive electrode profile.

The control unit 130 may be configured to diagnose the positive electrode SOH of the battery based on the extracted diagnosis factor.

Specifically, the control unit 130 may be configured to estimate the positive electrode SOH of the battery by comparing the value of the diagnosis factor with a criterion value preset for the diagnosis factor.

Here, the preset criterion value may be a value obtained in advance for a battery in a BOL (Beginning of Life) state. Preferably, the OCV profile Rocv for the battery in the BOL state may represent the correspondence relationship between OCV and capacity for the entire capacity range. The control unit 130 may determine the criterion value corresponding to the extracted diagnosis factor from the OCV profile Rocv for the battery in the BOL state. In other words, the criterion value is a state value of the battery in the BOL state, and the diagnosis factor is a state value of the battery in the current state. Accordingly, the control unit 130 may estimate the SOH of the battery based on the diagnosis factor indicating the current state of the battery and the criterion value indicating the BOL state of the battery.

The apparatus 100 for estimating a SOH according to an embodiment of the present disclosure may estimate the SOH of a battery based on the OCV of the battery measured under predetermined conditions. In other words, according to the present disclosure, there is an advantage that low-rate charging and discharging for SOH estimation is not mandatory.

For example, if low-rate charging and discharging at 0.05 C is required to estimate SOH, use of the battery may be limited for about 20 hours. In contrast, the apparatus 100 for estimating a SOH may estimate the SOH of a battery by only obtaining the OCV profile Rocv that includes a plurality of OCVs. Also, the conditions under which OCV is measured are conditions in which the use of the battery is not forcibly restricted. Therefore, since the apparatus 100 for estimating a SOH may quickly estimate the SOH of the battery based on the OCV profile Rocv without restricting the use of the battery, there is an advantage that the conventional problem in which the use of the battery must be excessively limited to estimate SOH may be solved.

Meanwhile, the control unit 130 included in the apparatus 100 for estimating a SOH optionally include a processor, an application-specific integrated circuit (ASIC), other chipset, a logic circuit, a register, a communication modem, a data processing device, etc. known in the art to execute various control logics performed in the present disclosure. Also, when the control logic is implemented as software, the control unit 130 may be implemented as a set of program modules. At this time, the program module may be stored in the memory and executed by the control unit 130. The memory may be inside or outside the control unit 130 and may be connected to the control unit 130 by various well-known means.

In addition, the apparatus 100 for estimating a SOH may further include a storage unit 140. The storage unit 140 may store data necessary for operation and function of each component of the apparatus 100 for estimating a SOH, data generated in the process of performing the operation or function, or the like. The storage unit 140 is not particularly limited in its kind as long as it is a known information storage means that may record, erase, update and read data. As an example, the information storage means may include RAM, flash memory, ROM, EEPROM, registers, and the like. In addition, the storage unit 140 may store program codes in which processes executable by the control unit 130 are defined.

For example, the storage unit 140 may store the OCV profile Rocv, the criterion positive electrode profile Rp, the criterion negative electrode profile Rn, the adjusted positive electrode profile, the adjusted negative electrode profile, and the diagnosis factor.

The plurality of OCVs may be configured to include a plurality of OCVs measured within a preset criterion period.

Specifically, the OCV may have limited measurement conditions. In other words, the time at which the plurality of OCVs are measured may be aperiodic. For example, it is assumed that the vehicle is started only once a day and that the stopping time of the vehicle is less than a criterion time. In this case, because OCV is measured only at the time point when the vehicle engine is turned on, one OCV may be measured per day. Therefore, the plurality of OCVs included in the OCV profile Rocv may be values measured with a time interval of one day.

Considering the OCV measurement conditions, a grouping condition for the plurality of OCVs used to estimate the SOH of the battery is needed. In other words, if the SOH of the battery is estimated using the plurality of OCVs obtained over an excessively long period of time, the battery may deteriorate further during that period, so the estimated SOH of the battery may not be accurate. Therefore, the OCV profile Rocv may only include a plurality of OCVs measured within the preset criterion period. Preferably, the criterion period may be set experimentally or theoretically, or may be set by considering the operating pattern (e.g., driving pattern or charge/discharge pattern) of the battery.

In one embodiment, the criterion period may be set to a preset target period. For example, the OCV profile Rocv may include a plurality of OCVs measured within last two weeks. Therefore, the SOH estimated based on the OCV profile Rocv, which includes only a plurality of OCVs measured within the criterion period, may well reflect the current state of the battery.

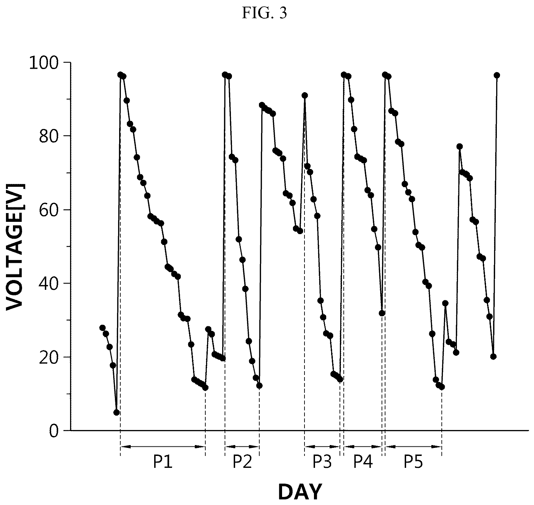

FIG. 3 is a diagram showing a measured OCV of the battery according to an embodiment of the present disclosure.

For example, in the embodiment of FIG. 3, the first to fifth periods P1, P2, P3, P4, P5 may be shorter than the preset criterion period. Therefore, the apparatus 100 for estimating a SOH may continuously diagnose the state of the battery by estimating the SOH of the battery based on the OCV profile Rocv for each of the first to fifth periods P1, P2, P3, P4, P5.

In another embodiment, the criterion period may be set to a period of time for measuring a preset number of OCVs. For example, the number of measured OCVs and the clarity or accuracy of the OCV profile Rocv are proportional. That is, the greater the number of measured OCVs, the clearer the OCV profile Rocv becomes, so that the result of adjusting the criterion positive electrode profile Rp and the criterion negative electrode profile Rn may better reflect the current state of the battery. Accordingly, the period of time until a preset number of non-overlapping OCVs (e.g., 30) are measured may be preset as the criterion period.

In another embodiment, the criterion period may be set as a period of time required for the SOH of the battery to decrease by a preset criterion SOH. For example, when the frequency of OCV measurement is low, there is a problem that a plurality of OCVs included in the OCV profile Rocv are measured at different SOHs. In this case, a problem occurs that the result of adjusting the criterion positive electrode profile Rp and the criterion negative electrode profile Rn based on the OCV profile Rocv reflects the past state of the battery. Therefore, a period of time required for the SOH of the battery to decrease by a preset criterion SOH (e.g., 0.1%) may be preset as the criterion period.

In another embodiment, the criterion period may be set to the shortest period among a preset target period, a period required to measure a preset number of OCVs, and a period required to decrease the SOH of the battery by the preset criterion SOH.

Although the above describes a limited example of a criterion period, it should be noted that the criterion period for generating an appropriate OCV profile Rocv used to diagnose the current state of a battery may be set by considering various aspects.

The apparatus 100 for estimating a SOH according to the present disclosure has an advantage of more accurately estimating the SOH of the battery by limiting the measurement time points of the plurality of OCVs used to estimate SOH.

Below, an embodiment in which the profile correcting unit 120 adjusts the criterion positive electrode profile Rp and the criterion negative electrode profile Rn will be described in detail.

The profile correcting unit 120 may be configured to generate a comparison full-cell profile S based on the criterion positive electrode profile Rp and the criterion negative electrode profile Rn.

Specifically, the comparison full-cell profile S may be generated according to the voltage difference per capacity (specifically, OCV difference) for the criterion positive electrode profile Rp and the criterion negative electrode profile Rn. For example, it is assumed that the voltage of the criterion positive electrode profile Rp corresponding to a certain capacity x is Vp, and the voltage of the criterion negative electrode profile Rn is Vn. The voltage of the comparison full-cell profile S corresponding to the capacity X may be calculated as "Vp - Vn". The profile correcting unit 120 may generate a comparison full-cell profile S by calculating the voltage difference between the criterion positive electrode profile Rp and the criterion negative electrode profile Rn for the entire capacity.

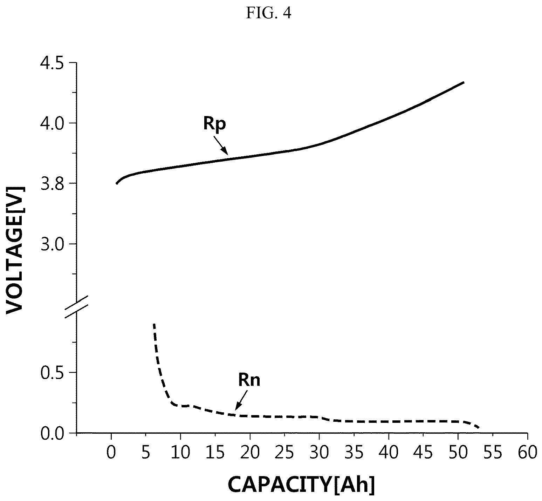

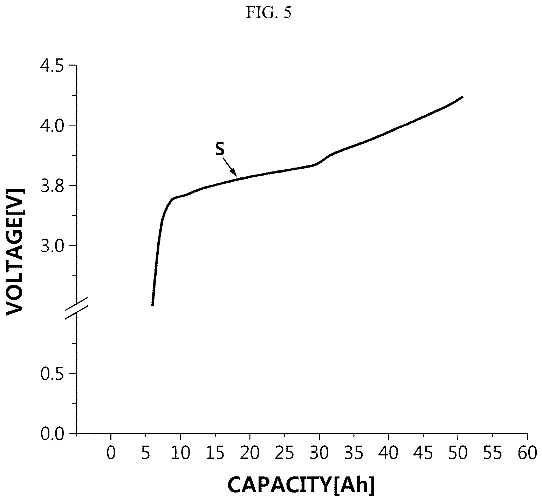

FIG. 4 is a diagram schematically showing a criterion positive electrode profile Rp and a criterion negative electrode profile Rn according to an embodiment of the present disclosure. FIG. 5 is a diagram schematically showing a comparison full-cell profile S according to an embodiment of the present disclosure. In the embodiment of FIGS. 4 and 5, the comparison full-cell profile S may be generated based on the voltage difference per capacity between the criterion positive electrode profile Rp and the criterion negative electrode profile Rn.

The profile correcting unit 120 may be configured to generate an adjusted positive electrode profile and an adjusted negative electrode profile by adjusting the criterion positive electrode profile Rp and the criterion negative electrode profile Rn until the generated comparison full-cell profile S corresponds to the OCV profile Rocv.

Specifically, the profile correcting unit 120 may calculate an error between the comparison full-cell profile S and the OCV profile Rocv. Additionally, the profile correcting unit 120 may adjust the criterion positive electrode profile Rp and the criterion negative electrode profile Rn until the error between the comparison full-cell profile S and the OCV profile Rocv is minimized. If the comparison full-cell profile S that minimizes the error with the OCV profile Rocv is determined, the adjusted positive electrode profile and the adjusted negative electrode profile, which are the basis of the determined comparison full-cell profile S, may be estimated as the positive electrode profile and the negative electrode profile that represent the current state of the battery. With current technology, there is a problem that it is not possible to directly obtain the positive electrode profile and the negative electrode profile indicating the current state of the battery without directly disassembling the battery. Therefore, it may be strongly assumed that the adjusted positive electrode profile and the adjusted negative electrode profile, which are the basis of the comparison full-cell profile S determined through the adjustment process, are the positive electrode profile and the negative electrode profile that reflect the current state of the battery.

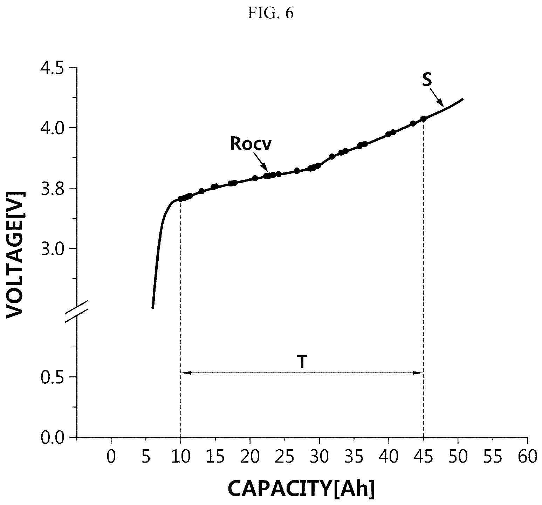

FIG. 6 is a diagram schematically showing a comparison full-cell profile S and an OCV profile Rocv according to an embodiment of the present disclosure. In the embodiment of FIG. 6, the profile correcting unit 120 may calculate an error between the two profiles based on the voltage difference per capacity of the comparison full-cell profile S and the OCV profile Rocv. Also, the profile correcting unit 120 may determine the comparison full-cell profile S in which the calculated error is minimized.

Preferably, the profile correcting unit 120 may be configured to determine a target capacity range T corresponding to the OCV profile Rocv.

For example, in the embodiment of FIG. 6, since the plurality of OCVs included in the OCV profile Rocv are measured aperiodically, the correspondence relationship between OCV and capacity may appear only in the target capacity range T. In other words, the target capacity range T is a capacity range of the OCV profile Rocv. Therefore, the profile correcting unit 120 may first determine the target capacity range T based on the OCV profile Rocv. For example, in the embodiment of FIG. 6, the target capacity range T may be determined to be a capacity range of 10 [Ah] or more and 45 [Ah] or less.

The profile correcting unit 120 may be configured to compare the comparison full-cell profile S and the OCV profile Rocv in the target capacity range T.

Specifically, since the comparison full-cell profile S is generated based on the criterion positive electrode profile Rp and the criterion negative electrode profile Rn, it may represent the correspondence relationship between voltage and capacity for the entire capacity range. In contrast, the OCV profile Rocv represents the correspondence relationship between OCV and capacity for the target capacity range T. Therefore, the profile correcting unit 120 may compare the two profiles only for the target capacity range T, which is the common capacity range of the comparison full-cell profile S and the OCV profile Rocv.

For example, in the embodiment of FIG. 6, the profile correcting unit 120 may compare the full-cell profile S and the OCV profile Rocv in the target capacity range T. Additionally, the profile correcting unit 120 may further adjust the criterion positive electrode profile Rp and the criterion negative electrode profile Rn according to the comparison results.

Below, diagnosis factors that the control unit 130 may select from the adjusted positive electrode profile and/or the adjusted negative electrode profile will be described in detail.

The control unit 130 may be configured to extract at least one of a positive electrode factor based on the adjusted positive electrode profile and a negative electrode factor based on the adjusted negative electrode profile as a diagnosis factor.

Here, the adjusted positive electrode profile is the result of adjusting the criterion positive electrode profile Rp, and the adjusted negative electrode profile is the result of adjusting the criterion negative electrode profile Rn. Specifically, as described above, the profile correcting unit 120 may adjust the criterion positive electrode profile Rp and the criterion negative electrode profile Rn so that the comparison full-cell profile S corresponds to the OCV profile Rocv.

The positive electrode factor may be configured to include at least one of the positive electrode participation initiating point pi, the positive electrode participation finalizing point pf and the positive electrode change rate ps of the battery based on the adjusted positive electrode profile.

The positive electrode participation initiating point pi may be a point corresponding to the starting capacity (lower limit capacity) of the target capacity range T in the adjusted positive electrode profile. For example, in the embodiment of FIG. 6, the starting capacity of the target capacity range T is 10 (Ah), so the point where the capacity value is 10 (Ah) in the adjusted positive electrode profile may be the positive electrode participation initiating point pi. Additionally, the value of the positive electrode participation initiating point pi may be a potential value or a SOC (State of Charge) value corresponding to the positive electrode participation initiating point pi in the adjusted positive electrode profile.

The positive electrode participation finalizing point pf may be a point corresponding to the ending capacity (upper limit capacity) of the target capacity range T in the adjusted positive electrode profile. For example, in the embodiment of FIG. 6, the ending capacity of the target capacity range T is 45 (Ah), so the point where the capacity value is 45 (Ah) in the adjusted positive electrode profile may be the positive electrode participation finalizing point pf. Also, the value of the positive electrode participation finalizing point pf may be a potential value or SOC value corresponding to the positive electrode participation finalizing point pf in the adjusted positive electrode profile.

The positive electrode change rate ps may mean the change rate [%] of the adjusted positive electrode profile with respect to the criterion positive electrode profile Rp. Specifically, the positive electrode change rate ps may be a contraction ratio or expansion ratio of the adjusted positive electrode profile with respect to the criterion positive electrode profile Rp. For example, if the adjusted positive electrode profile is a 10% contraction of from the criterion positive electrode profile Rp, the positive electrode change rate ps is 90%. Conversely, if the adjusted positive electrode profile is a 10% extension of the criterion positive electrode profile Rp, the positive electrode change rate ps is 110%.

The negative electrode factor may be configured to include at least one of a negative electrode participation initiating point ni, a negative electrode participation finalizing point nf, and a negative electrode change rate ns of the battery based on the adjusted negative electrode profile.

The negative electrode participation initiating point ni may be a point corresponding to the starting capacity (lower limit capacity) of the target capacity range T in the adjusted negative electrode profile. For example, in the embodiment of FIG. 6, the starting capacity of the target capacity range T is 10 (Ah), so the point where the capacity value is 10 (Ah) in the adjusted negative electrode profile may be the negative electrode participation initiating point ni. Also, the value of the negative electrode participation initiating point ni may be a potential value or SOC value corresponding to the negative electrode participation initiating point ni in the adjusted negative electrode profile.

The negative electrode participation finalizing point nf may be a point corresponding to the ending capacity (upper limit capacity) of the target capacity range T in the adjusted negative electrode profile. For example, in the embodiment of FIG. 6, the final capacity of the target capacity range T is 45 (Ah), so the point where the capacity value is 45 (Ah) in the adjusted negative electrode profile may be the negative electrode participation finalizing point nf. Also, the value of the negative electrode participation finalizing point nf may be a potential value or SOC value corresponding to the negative electrode participation finalizing point nf in the adjusted negative electrode profile.

The negative electrode change rate ns may mean the change rate [%] of the adjusted negative electrode profile with respect to the criterion negative electrode profile Rn. Specifically, the negative electrode change rate ns may be a contraction ratio or expansion ratio of the adjusted negative electrode profile with respect to the criterion negative electrode profile Rn. For example, if the adjusted negative electrode profile is a 10% contraction of from the criterion negative electrode profile Rn, the negative electrode change rate ns is 90%. Conversely, if the adjusted negative electrode profile is a 10% extension of the criterion negative electrode profile Rn, the negative electrode change rate ns is 110%.

The control unit 130 may be configured to estimate at least one of positive electrode SOH, negative electrode SOH, available lithium SOH, and capacity SOH for the battery depending on the type of diagnosis factor. Hereinafter, it will be explained that the values of the positive electrode participation initiating point pi and the positive electrode participation finalizing point pf refer to the corresponding SOCs in the adjusted positive electrode profile, and the values of the negative electrode participation initiating point ni and the negative electrode participation finalizing point nf refer to the corresponding SOCs in the adjusted negative electrode profile.

The positive electrode SOH indicates the degree of deterioration of the positive electrode of the battery. In other words, the positive electrode SOH is an indicator of the degree to which the positive electrode of the battery has deteriorated. As the battery deteriorates, the positive electrode reaction area decreases due to side reactions, etc., so the positive electrode capacity participating in the reaction may decrease. Accordingly, the control unit 130 may estimate the degree of deterioration for positive electrode capacity loss by calculating the positive electrode SOH.

Specifically, when the control unit 130 extracts the positive electrode participation finalizing point pf as a diagnosis factor, the positive electrode SOH may be calculated using Equation 1 or 2 below.

[Equation 1]

$$SOH_P = \frac{pf_{MOL} - pi_{BOL}}{pf_{BOL} - pi_{BOL}}$$

Here, $SOH_P$ is the positive electrode SOH, $pf_{MOL}$ is the value of the positive electrode participation finalizing point corresponding to the battery of the current state, $pf_{BOL}$ is the value of the positive electrode participation finalizing point corresponding to the battery of the BOL state, and $pi_{BOL}$ is the value of the positive electrode participation initiating point corresponding to the battery of the BOL state. Here, $pf_{BOL}$, $pi_{BOL}$, and $pf_{MOL}$ may be SOC values corresponding to the corresponding points.

[Equation 2]

$$SOH_P = \frac{pf_{MOL} - pi_{BOL}}{nf_{BOL} - ni_{BOL}}$$

Here, $nf_{BOL}$ is the value of the negative electrode participation finalizing point corresponding to the battery of the BOL state, and $ni_{BOL}$ is the value of the negative electrode participation initiating point corresponding to the battery of the BOL state. Here, $ni_{BOL}$ and $nf_{MOL}$ may be SOC values corresponding to the corresponding points.

For example, if $pi_{BOL}$ and $pf_{BOL}$ are set based on the positive electrode capacity of the BOL state, $ni_{BOL}$ and $nf_{BOL}$ may also be set based on the positive electrode capacity of the BOL state. As another example, if $pi_{BOL}$ and $pf_{BOL}$ are set based on the negative electrode capacity of the BOL state, $ni_{BOL}$ and $nf_{BOL}$ may also be set based on the negative electrode capacity of the BOL state. That is, the criterion capacity (positive electrode capacity or negative electrode capacity of the BOL state) that serves as the calculation criterion for $pi_{BOL}$, $pf_{BOL}$, $ni_{BOL}$, and $nf_{BOL}$ may be the same. Therefore, referring to Equations 1 and 2, "$pf_{BOL}-pi_{BOL}$" may be replaced with "$nf_{BOL}-ni_{BOL}$".

In addition, if the control unit 130 extracts the positive electrode change rate ps as a diagnosis factor, the positive electrode SOH may be calculated using Equation 3 below.

[Equation 3]

$$SOH_P = \frac{ps_{MOL}}{ps_{BOL}}$$

Here, $ps_{BOL}$ is the positive electrode change rate corresponding to the battery of the BOL state, and $ps_{MOL}$ is the positive electrode change rate corresponding to the battery of the current state. Specifically, $ps_{BOL}$ means the change rate of the criterion positive electrode profile Rp with respect to the initial positive electrode profile. Here, if the initial positive electrode profile and the criterion positive electrode profile Rp are the same, $ps_{BOL}$ may be 1 or 100%. Hereinafter, for the convenience of explanation, it is explained that the initial positive electrode profile and the criterion positive electrode profile Rp are the same. Also, $ps_{MOL}$ means the change rate of the adjusted positive electrode profile with respect to the criterion positive electrode profile Rp.

The negative electrode SOH indicates the degree of deterioration of the negative electrode of the battery. In other words, the negative electrode SOH is an indicator of the degree to which the negative electrode of the battery has deteriorated. As with the loss of the positive electrode capacity, as the battery deteriorates, the negative electrode reaction area decreases due to side reactions, etc., so the negative electrode capacity participating in the reaction may decrease. Accordingly, the control unit 130 may estimate the degree of deterioration for the negative electrode capacity loss by calculating the negative electrode SOH.

Specifically, when the control unit 130 extracts the negative electrode change rate ns as a diagnosis factor, the negative electrode SOH may be calculated using Equation 4 below.

[Equation 4]

$$SOH_N = \frac{ns_{MOL}}{ns_{BOL}}$$

Here, $SOH_N$ is the negative electrode SOH, $ns_{BOL}$ is the negative electrode change rate corresponding to the battery of the BOL state, and $ns_{MOL}$ is the negative electrode change rate corresponding to the battery of the current state. Specifically, $ns_{BOL}$ means the change rate of the criterion negative electrode profile Rn with respect to the initial negative electrode profile. Here, if the initial negative electrode profile and the criterion negative electrode profile Rn are the same, $ns_{BOL}$ may be 1 or 100%. Hereinafter, for the convenience of explanation, it is described that the initial negative electrode profile and the criterion negative electrode profile Rn are the same. Also, $ns_{MOL}$ means the change rate of the adjusted negative electrode profile with respect to the criterion negative electrode profile Rn.

The available lithium SOH indicates the degree of degradation of available lithium in the battery. In other words, the available lithium SOH is an indicator of the degree of degradation of lithium ions participating in the reaction. When lithium plating (Li-plating) occurs, lithium metal may precipitate on the surface of the negative electrode. As the lithium plating phenomenon progresses, the amount of lithium metal precipitated increases, so the number of lithium ions participating in the reaction may decrease. Therefore, the control unit 130 may estimate the degree of degradation relative to the number of lithium ions participating in the reaction compared to the initial reaction by calculating the available lithium SOH.

Specifically, when the control unit 130 extracts the positive electrode participation initiating point pi as diagnosis factors, the available lithium SOH may be calculated using Equation 5 or 6 below.

[Equation 5]

$$SOH_{Li} = \frac{pf_{BOL} - pi_{MOL}}{pf_{BOL} - pi_{BOL}}$$

[Equation 6]

$$SOH_{Li} = \frac{pf_{BOL} - pi_{MOL}}{nf_{BOL} - ni_{BOL}}$$

Here, $SOH_{Li}$ is the available lithium SOH. $pi_{MOL}$ is the value of the positive electrode participation initiating point corresponding to the battery of the current state. Here, $pi_{MOL}$ may be the SOC value corresponding to the corresponding point. Also, similar to Equations 1 and 2, referring to Equations 5 and 6, "$pf_{BOL}$-$pi_{BOL}$" may be replaced with "$nf_{BOL}$-$ni_{BOL}$".

The capacity SOH indicates the degree of degradation of the battery capacity. In other words, the capacity SOH is an indicator of the degree of degradation of the current available capacity compared to the initial capacity of the battery. As the battery deteriorates, the available capacity of the battery may naturally decrease. Therefore, the control unit 130 may estimate the degree of degradation of the current capacity compared to the initial one by calculating the capacity SOH.

Specifically, when the control unit 130 extracts the positive electrode participation finalizing point pf and the positive electrode participation initiating point pi as diagnosis factors, the capacity SOH may be calculated using Equation 7 below.

[Equation 7]

$$SOH_Q = \frac{pf_{MOL} - pi_{MOL}}{pf_{BOL} - pi_{BOL}}$$

Here, $SOH_Q$ is capacity SOH. $pf_{BOL}$, $pi_{BOL}$, $pf_{MOL}$, and $pi_{MOL}$ are as described above. Also, "$pf_{BOL}$-$pi_{BOL}$" may be replaced with "$nf_{BOL}$-$ni_{BOL}$".

In addition, if the control unit 130 extracts the negative electrode participation finalizing point nf and the negative electrode participation initiating point ni as diagnosis factors, the capacity SOH may be calculated using Equation 8 below.

[Equation 8]

$$SOH_Q = \frac{nf_{MOL} - ni_{MOL}}{nf_{BOL} - ni_{BOL}}$$

Here, $SOH_Q$ is the capacity SOH, $nf_{MOL}$ is the value of the negative electrode participation finalizing point corresponding to the battery of the current state, and $ni_{MOL}$ is the value of the negative electrode participation initiating point corresponding to the battery of the current state. That is, referring to Equations 7 and 8, "$pf_{BOL}$-$pi_{BOL}$" may be replaced with "$nf_{BOL}$-$ni_{BOL}$", and "$pf_{MOL}$-$pi_{MOL}$" may be replaced with "$nf_{MOL}$-$ni_{MOL}$".

In the above, an embodiment in which the control unit 130 estimates the positive electrode SOH ($SOH_P$), the negative electrode SOH ($SOH_N$), the available lithium SOH ($SOH_{Li}$), and the capacity SOH ($SOH_Q$) has been described. However, the control unit 130 may also estimate the positive electrode deterioration rate, the negative electrode deterioration rate, the available lithium deterioration rate, and the capacity deterioration rate by calculating the complement of 1 (or 100%) of the SOH. For example, the control unit 130 may estimate the positive electrode deterioration rate by calculating "1- positive electrode SOH".

The apparatus 100 for estimating a SOH according to an embodiment of the present disclosure may estimate the SOH of a battery from various aspects depending on the extracted diagnosis factor. For example, according to the extracted diagnosis factor, it is possible to estimate the positive electrode SOH, the negative electrode SOH, the available lithium SOH, and the capacity SOH, so the degree of battery degradation for each item may be specifically diagnosed.

The control unit 130 may be configured to adjust usage conditions for the battery based on the estimated SOH.

Specifically, the control unit 130 may adjust the available SOC range for the battery based on the estimated SOH. For example, the control unit 130 may reduce the upper limit of the available SOC range for the battery. As another example, the control unit 130 may increase the lower limit of the available SOC range for the battery. As another example, the control unit 130 may decrease the upper limit of the available SOC range for the battery and increase the lower limit of the available SOC range.

Through adjustment of the available SOC range, loss of positive electrode response area and negative electrode response area may be prevented. Additionally, because loss of available lithium is prevented, lithium metal may be prevented from precipitating. Additionally, the generation of gas inside the battery may be suppressed.

Hereinafter, with reference to FIGS. 7 to 14, an embodiment in which the profile correcting unit 120 adjusts the criterion positive electrode profile Rp and the criterion negative electrode profile Rn will be described in more detail.

FIGS. 7 to 14 are diagrams for explaining the process of adjusting a criterion positive electrode profile Rp and a criterion negative electrode profile Rn according to an embodiment of the present disclosure.

FIG. 7 is a graph referenced to for explaining an example of the criterion positive electrode profile Rp and the criterion negative electrode profile Rn, respectively. In the graph of FIG. 7, the horizontal axis (X-axis) represents capacity (Ah) and the vertical axis (Y-axis) represents voltage (V).

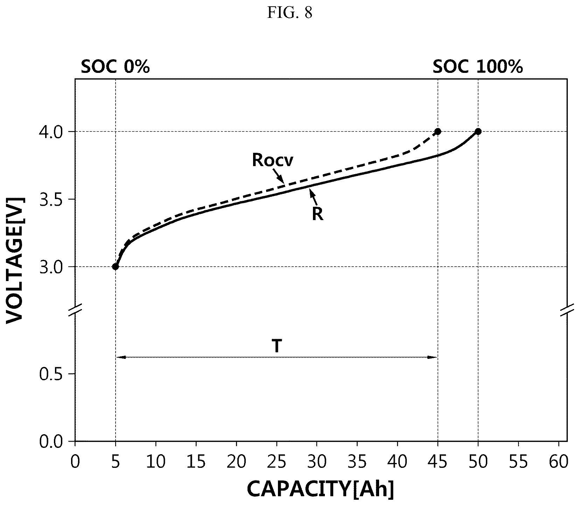

FIG. 8 is a graph referenced to for explaining an example of the OCV profile Rocv of the target battery. In the graph of FIG. 8, the horizontal axis (X-axis) represents capacity (Ah) and the vertical axis (Y-axis) represents voltage (V). Referring to FIG. 8, it is assumed that the target capacity range T is a capacity range of 5 (Ah) to 45 (Ah).

The profile correcting unit 120 may be configured to compare the OCV profile Rocv and at least one comparison full-cell profile S. Here, the comparison full-cell profile S may be the result of synthesizing (combining) the adjusted positive electrode profile and the adjusted negative electrode profile based on the criterion positive electrode profile Rp and the criterion negative electrode profile Rn, respectively, stored in the storage unit 140.

In other words, when the criterion full-cell profile R is the result of subtracting a part of the criterion negative electrode profile Rn from a part of the criterion positive electrode profile Rp, the comparison full-cell profile S may be said to be the result of subtracting a part of the adjusted negative electrode profile from a part of the adjusted positive electrode profile.

The profile correcting unit 120 may generate at least one comparison full-cell profile S by directly adjusting the criterion positive electrode profile Rp and the criterion negative electrode profile Rn. Alternatively, at least one comparison full-cell profile S may be secured in advance based on the criterion positive electrode profile Rp and the criterion negative electrode profile Rn and stored in the storage unit 140. In this case, the profile correcting unit 120 may obtain the comparison full-cell profile S in the form of accessing the storage unit 140 and reading the comparison full-cell profile S.

The profile correcting unit 120 may generate a plurality of comparison full-cell profile from the criterion positive electrode profile Rp and the criterion negative electrode profile Rn by repeating the process of adjusting each of the criterion positive electrode profile Rp and the criterion negative electrode profile Rn to various levels and then synthesizing them. The comparison full-cell profile S may also be called an 'adjusted criterion full-cell profile'.

The profile correcting unit 120 may specify any one comparison full-cell profile S that has a minimum error with the OCV profile Rocv among the plurality of comparison full-cell profile.

Next, the profile correcting unit 120 may determine that the adjusted positive electrode profile and the adjusted negative electrode profile mapped to the specified comparison full-cell profile S are the positive electrode profile and the negative electrode profile of the battery. In the following, it should be noted that the positive electrode profile is a finally determined adjusted positive electrode profile, and the negative electrode profile is a finally determined adjusted negative electrode profile.

In relation to this, various methods known at the filing time of the present disclosure may be employed to determine the error between two profiles, each of which may be expressed in a two-dimensional coordinate system. For example, the integral value of the absolute value of the area between two profiles or RMSE (Root Mean Square Error) may be used as the error between two profiles.

According to this configuration of the present disclosure, various state information about the battery may be obtained based on the finally determined positive electrode profile and negative electrode profile. The finally determined positive electrode profile and negative electrode profile may be mapped to the comparison full-cell profile S mapped to the minimum error. In particular, it may be said that the comparison full-cell profile S based on the finally determined positive electrode profile and negative electrode profile is almost identical to OCV profile Rocv in terms of shape.

Therefore, according to the present disclosure, the positive electrode profile and the negative electrode profile of the battery may be obtained even without disassembling the battery.

If the battery is a new battery, the positive electrode profile and the negative electrode profile of the battery may be analyzed to more easily diagnose whether a defect has occurred in the battery and, if so, what type of defect it is.

If the battery is being used after it has been verified to be a good product, it is possible to determine the extent to which the battery has deteriorated for each deterioration item through the positive electrode profile and the negative electrode profile of the battery.

Moreover, according to an embodiment of the present disclosure, the positive electrode profile and the negative electrode profile of the battery may be obtained in a simple manner. Even if only one criterion positive electrode profile Rp and one criterion negative electrode profile Rn are stored in the storage unit 140, the present disclosure may be implemented. That is, there is no need to store a plurality of criterion positive electrode profiles Rp and/or a plurality of criterion negative electrode profiles Rn in the storage unit 140. Accordingly, the storage capacity of the storage unit 140 does not need to be high, and there is no need to conduct numerous preliminary tests required to secure a plurality of criterion positive electrode profiles Rp and/or a plurality of criterion negative electrode profiles Rn.

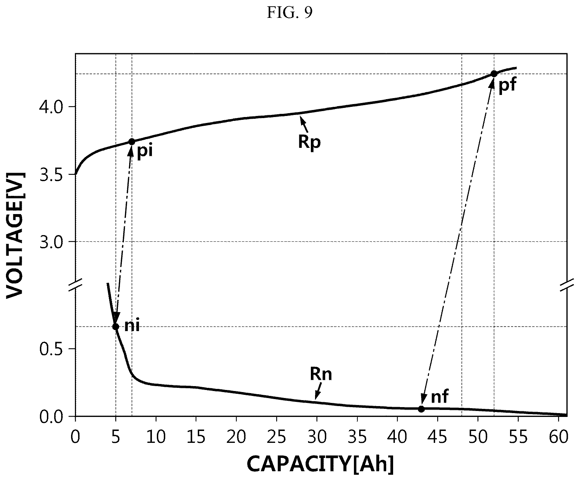

FIGS. 9 to 11 are diagrams referenced to for explaining an example of a procedure for generating a comparison full-cell profile S used for comparison with the OCV profile Rocv according to an embodiment of the present disclosure.

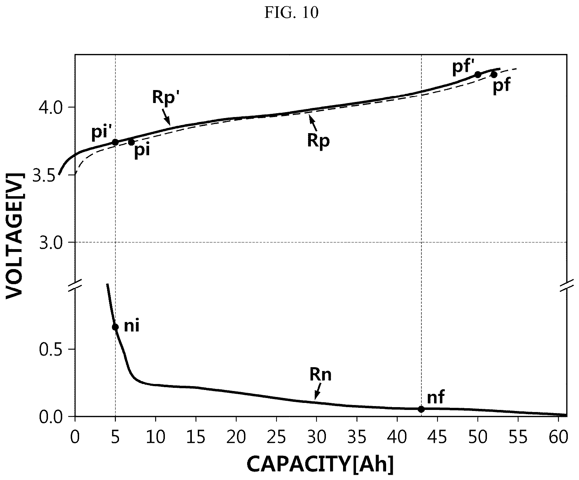

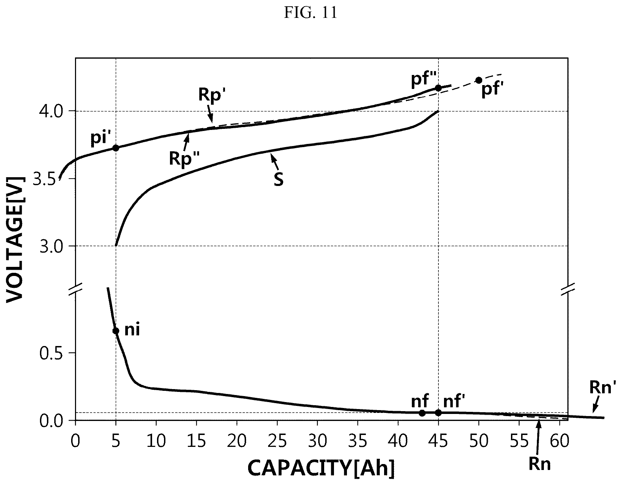

The procedure for generating a comparison full-cell profile S, which will be described with reference to FIGS. 9 to 11, proceeds in the following order: a first routine that sets four points (positive electrode participation initiating point, positive electrode participation finalizing point, negative electrode participation initiating point, negative electrode participation finalizing point) to correspond to the voltage range of interest (see FIG. 9), a second routine that performs profile shifting (see FIG. 10), and a third routine that performs capacity scaling (see FIG. 11). That is, the procedure for generating a comparison full-cell profile S according to an embodiment of the present disclosure includes the first to third routines.

First, referring to FIG. 9, the criterion positive electrode profile Rp and the criterion negative electrode profile Rn are the same as those shown in FIG. 7.

The profile correcting unit 120 determines a positive electrode participation initiating point pi, a positive electrode participation finalizing point pf, a negative electrode participation initiating point ni, and a negative electrode participation finalizing point nf on the criterion positive electrode profile Rp and the criterion negative electrode profile Rn.

Either the positive electrode participation initiating point pi or the negative electrode participation initiating point ni depends on the other.

As an example, the profile correcting unit 120 divides the positive electrode voltage range from the starting point of the criterion positive electrode profile Rp to the end point (or second setting voltage) into a plurality of micro voltage sections, and then set the boundary point of two adjacent micro voltage sections among the plurality of micro voltage sections as the positive electrode participation initiating point pi. Each micro voltage section may have a predetermined size (e.g., 0.01 V). Next, the profile correcting unit 120 may set a point on the criterion negative electrode profile Rn, which is smaller than the positive electrode participation initiating point pi by the first setting voltage (e.g., 3 V), as the negative electrode participation initiating point ni.

As another example, the profile correcting unit 120 may divide the negative electrode voltage range from the start point to the end point of the criterion negative electrode profile Rn into a plurality of micro voltage sections of a predetermined size, and then set the boundary point of two adjacent micro voltage sections among the plurality of micro voltage sections as the negative electrode participation initiating point ni. Next, the profile correcting unit 120 may search for a point, which is greater than the negative electrode participation initiating point ni by the first setting voltage, from the criterion positive electrode profile Rp and set the searched point as the positive electrode participation initiating point pi.

Either the positive electrode participation finalizing point pf and the negative electrode participation finalizing point nf depends on the other.

As an example, the profile correcting unit 120 may divide the voltage range from the second setting voltage to the end point of the criterion positive electrode profile Rp into a plurality of micro voltage sections of a predetermined size, and then set the boundary point of two adjacent micro voltage sections among the plurality of micro voltage sections as the positive electrode participation finalizing point pf. Next, the profile correcting unit 120 may set a point on the criterion negative electrode profile Rn, which is smaller than the positive electrode participation finalizing point pf by a second setting voltage (e.g., 4 V), as the negative electrode participation finalizing point nf.

As another example, the profile correcting unit 120 may divide the negative electrode voltage range from the start point to the end point of the criterion negative electrode profile Rn into a plurality of micro voltage sections of a predetermined size, and then set the boundary point of two adjacent micro voltage sections among the plurality of micro voltage sections as the negative electrode participation finalizing point nf. Next, the profile correcting unit 120 may search for a point, which is greater than the negative electrode participation finalizing point nf by a second setting voltage, from the criterion positive electrode profile Rp and set the searched point as the positive electrode participation finalizing point pf.

If the determination of the positive electrode participation initiating point pi, the positive electrode participation finalizing point pf, the negative electrode participation initiating point ni, and the negative electrode participation finalizing point nf is completed, the profile correcting unit 120 shifts at least one of the criterion positive electrode profile Rp and the criterion negative electrode profile Rn to the left or right along the horizontal axis.

Referring to FIG. 10, the profile correcting unit 120 may shift the criterion positive electrode profile Rp and/or the criterion negative electrode profile Rn so that the capacity values of the positive electrode participation initiating point pi and the negative electrode participation initiating point ni match.

Alternatively, the profile correcting unit 120 may shift the criterion positive electrode profile Rp and/or the criterion negative electrode profile Rn so that the voltages of the positive electrode participation finalizing point pf and the negative electrode participation finalizing point nf match.

FIG. 10 shows the situation that the adjusted criterion positive electrode profile Rp' is generated by shifting only the criterion positive electrode profile Rp to the left, and as a result, the voltage of the positive electrode participation initiating point pi' matches the voltage of the negative electrode participation initiating point ni. The adjusted criterion positive electrode profile Rp' is the result of applying an adjustment procedure of shifting to the left by the voltage difference between the positive electrode participation initiating point pi and the negative electrode participation initiating point ni to the criterion positive electrode profile Rp. Therefore, the two points pi, pi' differ only in capacity value and have the same voltage. The two points pf, pf' differ only in capacity value and have the same voltage.

When the adjustment result profiles Rp', Rn in which at least one of the criterion positive electrode profile Rp and the criterion negative electrode profile Rn is shifted are secured, the profile correcting unit 120 scales the capacity range of at least one of the adjustment result profiles Rp', Rn.

According to the example shown in FIG. 11, the profile correcting unit 120 performs an additional adjustment procedure to shrink or expand at least one of the adjusted criterion positive electrode profile Rp' and the adjusted criterion negative electrode profile Rn along the horizontal axis.

Referring to FIG. 11, the profile correcting unit 120 may generate an adjusted criterion positive electrode profile Rp" by shrinking or expanding the adjusted criterion positive electrode profile Rp' so that the size of the capacity range between the two points pi', pf' of the adjusted criterion positive electrode profile Rp' matches the size of the target capacity range T of the OCV profile Rocv. At this time, any one of the two points pi', pf' may be fixed. Accordingly, the capacity difference between the two points pi', pf" of the adjusted criterion positive electrode profile Rp" may be matched to the target capacity range T of the OCV profile Rocv.

In addition, the profile correcting unit 120 may generate an adjusted criterion negative electrode profile Rn' by shrinking or expanding the criterion negative electrode profile Rn so that the size of the capacity range between two points ni, nf of the criterion negative electrode profile Rn matches the size of the target capacity range T of the OCV profile Rocv. At this time, any one of the two points ni, nf may be fixed. Accordingly, the capacity difference between the two points ni, nf' of the adjusted criterion negative electrode profile Rn' may be matched to the target capacity range T of the OCV profile Rocv.

In FIG. 11, the adjusted criterion positive electrode profile Rp" is the result of shrinkage of the adjusted criterion positive electrode profile Rp' shown in FIG. 10, and the adjusted criterion negative electrode profile Rn' is the result of expansion of the criterion negative electrode profile Rn shown in FIG. 10.

The positive electrode participation finalizing point pf" on the adjusted criterion positive electrode profile Rp" corresponds to the positive electrode participation finalizing point pf on the adjusted criterion positive electrode profile Rp'. The negative electrode participation finalizing point nf' on the adjusted criterion negative electrode profile Rn' corresponds to the negative electrode participation finalizing point nf on the criterion negative electrode profile Rn.

The capacity difference between the positive electrode participation initiating point pi' and the positive electrode participation finalizing point pf" of the adjusted criterion positive electrode profile Rp" corresponds to the size of the target capacity range T of the OCV profile Rocv. Likewise, the capacity difference between the negative electrode participation initiating point ni and the negative electrode participation finalizing point nf' of the adjusted criterion negative electrode profile Rn' corresponds to the size of the target capacity range T of the OCV profile Rocv.

In addition, the capacity range by two points pi', pf" of the adjusted criterion positive electrode profile Rp" matches the capacity range by two points ni, nf' of the adjusted criterion negative electrode profile Rn'. The profile correcting unit 120 may generate the comparison full-cell profile S by subtracting the profile between two points pi, pf' of the adjusted criterion positive electrode profile Rp" from the profile between two points ni, nf' of the adjusted criterion negative electrode profile Rn'.

The profile correcting unit 120 may calculate the error (profile error) between the comparison full-cell profile S and the OCV profile Rocv. When the error between the comparison full-cell profile S and the OCV profile Rocv is minimized, the adjusted criterion positive electrode profile Rp" corresponding to the comparison full-cell profile S may be determined as the adjusted positive electrode profile, and the adjusted criterion negative electrode profile Rn' may be determined as the adjusted negative electrode profile.

The profile correcting unit 120 may map at least two of the adjusted criterion positive electrode profile Rp", the adjusted criterion negative electrode profile Rn', the positive electrode participation initiating point pi', the positive electrode participation finalizing point pf", the negative electrode participation initiating point ni, the negative electrode participation finalizing point nf', the first scale factor, the second scale factor, the comparison full-cell profile S, and the profile error to each other and record in the storage unit 140. The first scale factor may represent the rate of the capacity difference between two points pi', pf" relative to the capacity difference between two points pi0, pf0. The second scale factor may represent the rate of the capacity difference between two points ni, nf' relative to the capacity difference between two points ni0, nf0.

Here, the profile correcting unit 120 may calculate the positive electrode change rate ps of the adjusted criterion positive electrode profile Rp" for the criterion positive electrode profile Rp. Also, the profile correcting unit 120 may calculate the negative electrode change rate ns of the adjusted criterion positive electrode profile Rn' for the criterion negative electrode profile Rn. For example, the profile correcting unit 120 may determine the first scale factor as the positive electrode change rate ps and determine the second scale factor as the negative electrode change rate ns.

Meanwhile, as described above, when the positive electrode voltage range of the criterion positive electrode profile Rp is divided into a plurality of micro voltage sections, the boundary point of two adjacent micro voltage sections among the plurality of micro voltage sections may be set as the positive electrode participation initiating point pi.

For example, if the positive electrode voltage range of the criterion positive electrode profile Rp is divided into one hundred small voltage ranges, there may be one hundred boundary points that may be set as the positive electrode participation initiating point pi. In addition, if the voltage range equal to or greater than the second setting voltage in the criterion positive electrode profile Rp is divided into 40 small voltage ranges, there may be 40 boundary points that may be set as the positive electrode participation finalizing point pf. In this case, up to 4000 different comparison full-cell profile may be generated.

Of course, it will be easy to understand by those skilled in the art that as the size of the micro voltage section decreases, the number of comparison full-cell profile that may be maximally generated increases, and conversely, as the size of the micro voltage section increases, the number of comparison full-cell profile that may be maximally generated decreases.

The profile correcting unit 120 may identify the minimum value among the profile errors of the plurality of comparison full-cell profile S generated as described above, and then obtain information mapped to the minimum profile error (e.g., at least one of the positive electrode participation initiating point pi, the positive electrode participation finalizing point pf, the negative electrode participation initiating point ni, the negative electrode participation finalizing point nf, the positive electrode change rate ps, and the negative electrode change rate ns) from the storage unit 140.

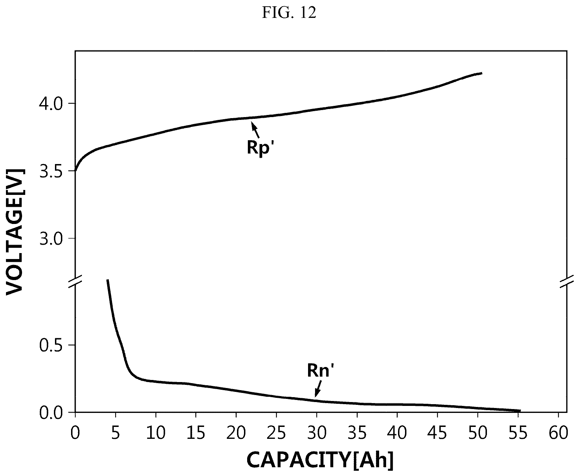

FIGS. 12 to 14 are diagrams referenced to for explaining another example of a procedure for generating a comparison full-cell profile S used for comparison with the OCV profile Rocv according to an embodiment of the present disclosure. For reference, the embodiments shown in FIGS. 12 to 14 are independent from the embodiments shown in FIGS. 9 to 11. Accordingly, terms or symbols commonly used in describing the embodiments shown in FIGS. 9 to 11 and the embodiments shown in FIGS. 12 to 14 should be understood as being limited to each embodiment.

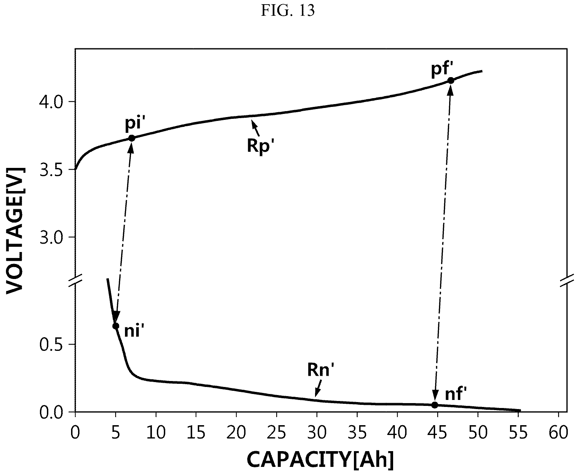

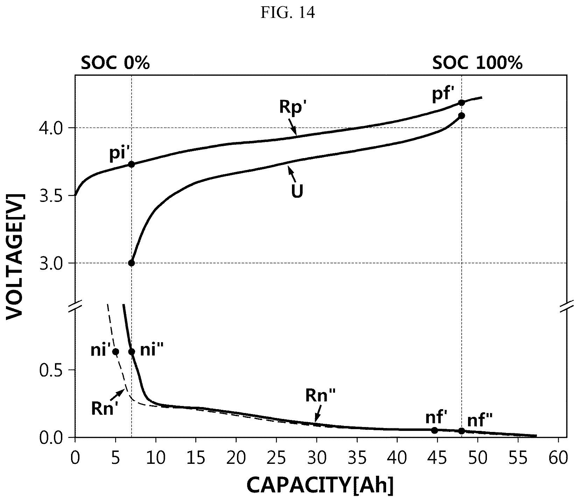

The generation procedure of the comparison full-cell profile S to be explained with reference to FIGS. 12 to 14 proceeds in the following order: a fourth routine for performing capacity scaling (see FIG. 12), a fifth routine of setting four points (the positive electrode participation initiating point, the positive electrode participation finalizing point, the negative electrode participation initiating point and the negative electrode participation finalizing point (see FIG. 13), and a sixth routine of performing profile shift (see FIG. 14). That is, the generation procedure of the comparison full-cell profile S according to another embodiment of the present disclosure includes the fourth to sixth routine.

Referring to FIG. 12, the criterion positive electrode profile Rp and the criterion negative electrode profile Rn are the same as those shown in FIG. 7.

The profile correcting unit 120 generates an adjusted criterion positive electrode profile Rp' and an adjusted criterion negative electrode profile Rn' by applying the first scale factor and the second scale factor selected from the scaling value range to the criterion positive electrode profile Rp and the criterion negative electrode profile Rn, respectively.

The scaling value range may be predetermined or may vary depending on the rate of the size of the target capacity range T of the OCV profile Rocv relative to the size of the capacity range of the criterion full-cell profile R. As an example, assuming that the first scale factor and the second scale factor may be selected among the values spaced by 0.1% (i.e., 90%, 90.1%, 90.2%, ..., 98.9%, 99%) in the scaling numerical range (e.g., 90 to 99%), 91 values may be selected as the first scale factor and the second scale factor, respectively. In this case, up to 8,281 adjusted profile pairs may be generated to 91×91=8,281 adjustment levels (combination of first scale factor and second scale factor). The adjusted profile pair refers to a combination of the adjusted criterion positive electrode profile Rp and the adjusted criterion negative electrode profile Rn.

FIG. 12 shows an example in which the adjusted criterion positive electrode profile Rp' and the adjusted criterion negative electrode profile Rn' are the results of applying a first scale factor and a second scale factor less than 100% to the criterion positive electrode profile Rp and the criterion negative electrode profile Rn, respectively.

Since the first scale factor and the second scale factor are less than 100%, the adjusted criterion positive electrode profile Rp' is the shrinkage of the criterion positive electrode profile Rp along the horizontal axis, and the adjusted criterion negative electrode profile Rn' is also the shrinkage of the criterion negative electrode profile Rn along the horizontal axis. To facilitate understanding, the example is illustrated in the form where the starting point of each of the criterion positive electrode profile Rp and the criterion negative electrode profile Rn is fixed and the remaining portions are reduced to the left along the horizontal axis.

Referring to FIG. 13, the profile correcting unit 120 determines the positive electrode participation initiating point pi', the positive electrode participation finalizing point pf', the negative electrode participation initiating point ni' and the negative electrode participation finalizing point nf' on the adjusted criterion positive electrode profile Rp' and the adjusted criterion negative electrode profile Rn'.

Either the positive electrode participation initiating point pi' or the negative electrode participation initiating point ni' may depend on the other. Additionally, either the positive electrode participation finalizing point pf' or the negative electrode participation finalizing point nf' may depend on the other. Additionally, either the positive electrode participation initiating point pi' or the positive electrode participation finalizing point pf' may be set based on the other.

That is, if any one of the positive electrode participation initiating point pi', the positive electrode participation finalizing point pf', the negative electrode participation initiating point ni', and the negative electrode participation finalizing point nf' is set, the remaining three points may be set automatically by the first setting voltage, the second setting voltage and/or the size of the target capacity range T of the OCV profile Rocv (e.g., charging capacity of SOC 0% to 100%).

As an example, the profile correcting unit 120 may divide the positive electrode voltage range from the start point of the adjusted criterion positive electrode profile Rp' to the end point (or second setting voltage) into a plurality of micro voltage section, and then set the boundary point of two adjacent micro voltage sections among the plurality of micro voltage sections as the positive electrode participation initiating point pi'. Next, the profile correcting unit 120 may set the point on the adjusted criterion negative electrode profile Rn, which is smaller than the positive electrode participation initiating point pi' by the first setting voltage (e.g., 3 V), as the negative electrode participation initiating point ni'.

As another example, the profile correcting unit 120 may divide the negative electrode voltage range from the start point to the end point of the adjusted criterion negative electrode profile Rn' into a plurality of micro voltage sections of a predetermined size, and then set the boundary point of two adjacent voltage sections among the plurality of micro voltage sections as the negative electrode participation initiating point ni'. Next, the profile correcting unit 120 may search for a point, which is greater than the negative electrode participation initiating point ni' by the first setting voltage, from the criterion positive electrode profile Rp and set the searched point as the positive electrode participation initiating point pi'.

As another example, the profile correcting unit 120 may divide the voltage range from the second setting voltage to the end point of the adjusted criterion positive electrode profile Rp' into a plurality of micro voltage sections of a predetermined size, and then set the boundary point of the two micro voltage sections among the plurality of micro voltage sections as the positive electrode participation finalizing point pf. Next, the profile correcting unit 120 may search for a point, which is smaller than the positive electrode participation finalizing point pf' by the second setting voltage (e.g., 4 V), in the adjusted criterion negative electrode profile Rn', and set the searched point as the negative electrode participation finalizing point 'nf'.

As another example, the profile correcting unit 120 may divide the negative electrode voltage range from the start point to the end point of the adjusted criterion negative electrode profile Rn' into a plurality of micro voltage sections of a predetermined size, and then set the boundary point of two adjacent micro voltage sections among the plurality of micro voltage sections as the negative electrode participation finalizing point nf'. Next, the profile correcting unit 120 may search for a point, which is greater than the negative electrode participation finalizing point nf' by the second setting voltage, from the adjusted criterion positive electrode profile Rp' and set the searched point as the positive electrode participation finalizing point pf'.

If any one of the positive electrode participation initiating point pi', the positive electrode participation finalizing point pf', the negative electrode participation initiating point ni', and the negative electrode participation finalizing point nf' is determined, the profile correcting unit 120 may additionally determine the remaining points based on the determined point.

As an example, if the positive electrode participation initiating point pi' is determined first, the profile correcting unit 120 may set the point on the adjusted criterion positive electrode profile Rp', which has a capacity value that is larger than the capacity value of the positive electrode participation initiating point pi' by the size of the target capacity range T of the OCV profile Rocv, as the positive electrode participation finalizing point pf'. Additionally, the profile correcting unit 120 may search for a point, which is lower than the positive electrode participation initiating point pi' by the first setting voltage, from the adjusted criterion negative electrode profile Rn' and set the searched point as the negative electrode participation initiating point ni'. In addition, the profile correcting unit 120 may set a point on the adjusted criterion negative electrode profile Rn', which has a capacity value larger than the capacity value of the negative electrode participation initiating point ni' by the size of the target capacity range T of the OCV profile Rocv, as the negative electrode participation finalizing point nf'.

As another example, if the positive electrode participation finalizing point pf' is determined first, the profile correcting unit 120 may set a point on the adjusted criterion positive electrode profile Rp', which has a capacity value smaller than the capacity value of the positive electrode participation finalizing point pf' by the size of the target capacity range T of the OCV profile Rocv, as the positive electrode participation initiating point pi'. Additionally, the profile correcting unit 120 may search for a point, which is lower than the positive electrode participation finalizing point pf' by the second setting voltage, from the adjusted criterion negative electrode profile Rn' and set the searched point as the negative electrode participation finalizing point nf'. In addition, the profile correcting unit 120 may set a point on the adjusted criterion negative electrode profile Rn', which has a capacity value smaller than the capacity value of the negative electrode participation finalizing point nf' by the size of the target capacity range T of the OCV profile Rocv, as the negative electrode participation initiating point ni'.

As still another example, if the negative electrode participation initiating point ni' is determined, the profile correcting unit 120 may set a point on the criterion negative electrode profile Rn', which has a capacity value larger than the capacity value of the negative electrode participation initiating point ni' by the size of the target capacity range T of the OCV profile Rocv, set as the negative electrode participation finalizing point nf'. Additionally, the profile correcting unit 120 may search for a point, which is higher than the negative electrode participation initiating point ni' by the first setting voltage, from the adjusted criterion positive electrode profile Rp' and set the searched point as the positive electrode participation initiating point pi'. In addition, the profile correcting unit 120 may set a point on the adjusted criterion positive electrode profile Rp', which has a capacity value greater than the capacity value of the positive electrode participation initiating point pi' by the size of the target capacity range T of the OCV profile Rocv, as the positive electrode participation finalizing point pf'.

As still another example, if the negative electrode participation finalizing point nf' is determined, the profile correcting unit 120 may set a point on the criterion negative electrode profile Rn', which has a capacity value smaller than the capacity value of the negative electrode participation finalizing point nf' by the size of the target capacity range T of the OCV profile Rocv, as the negative electrode participation initiating point ni'. Additionally, the profile correcting unit 120 may search for a point, which is higher than the negative electrode participation finalizing point nf' by the second setting voltage, from the adjusted criterion positive electrode profile Rp' and set the searched point as the positive electrode participation finalizing point pf'. In addition, the profile correcting unit 120 may set a point on the adjusted criterion positive electrode profile Rp', which has a capacity value smaller than the capacity value of the positive electrode participation finalizing point pf' by the size of the target capacity range T of the OCV profile Rocv, as the positive electrode participation initiating point pi'.

If the determination of the positive electrode participation initiating point pi', the positive electrode participation finalizing point pf', the negative electrode participation initiating point ni' and the negative electrode participation finalizing point nf' is completed based on the pair of first scale factor and second scale factor, the profile correcting unit 120 may shift at least one of the adjusted criterion positive electrode profile Rp' and the adjusted criterion negative electrode profile Rn' along the horizontal axis so that the capacity values of the positive electrode participation initiating point pi' and the negative electrode participation initiating point ni' match or the capacity values of the positive electrode participation finalizing point pf' and the negative electrode participation finalizing point nf' match.

The adjusted criterion negative electrode profile Rn" shown in FIG. 14 is obtained by shifting only the adjusted criterion negative electrode profile Rn' shown in FIG. 13 to the right. Accordingly, the capacity values of the positive electrode participation initiating point pi' and the negative electrode participation initiating point ni" match each other. In this regard, since the capacity difference between the positive electrode participation initiating point pi' and the positive electrode participation finalizing point pf' is the same as the capacity difference between the negative electrode participation initiating point ni' and the negative electrode participation finalizing point nf', if the capacity values of the positive electrode participation initiating point pi' and the negative electrode participation initiating point ni" match each other, the capacity values of the positive electrode participation finalizing point pf' and the negative electrode participation finalizing point nf" also match each other.

Referring to FIG. 14, the profile correcting unit 120 may generate the comparison full-cell profile U by subtracting a partial profile between two points pi', pf' of the adjusted criterion positive electrode profile Rp' from the partial profile between into two points ni", nf" of the adjusted criterion negative electrode profile Rn".

The profile correcting unit 120 may calculate the error (profile error) between the comparison full-cell profile U and the OCV profile Rocv. When the error between the comparison full-cell profile U and the OCV profile Rocv is minimized, the adjusted criterion positive electrode profile Rp' corresponding to the comparison full-cell profile U may be determined as the adjusted positive electrode profile, and the adjusted criterion negative electrode profile Rn" may be determined as the adjusted negative electrode profile.

The profile correcting unit 120 may map at least two of the adjusted criterion positive electrode profile Rp', the adjusted criterion negative electrode profile Rn", the positive electrode participation initiating point pi', the positive electrode participation finalizing point pf', the negative electrode participation initiating point ni", the negative electrode participation finalizing point nf", the positive electrode change rate ps, the negative electrode change rate ns, the comparison full-cell profile U, and the profile error with each other and record in the storage unit 140.

Here, the profile correcting unit 120 may calculate the positive electrode change rate ps of the adjusted criterion positive electrode profile Rp' for the criterion positive electrode profile Rp. Also, the profile correcting unit 120 may calculate the negative electrode change rate ns of the adjusted criterion negative electrode profile Rn" for the criterion negative electrode profile Rn. For example, the profile correcting unit 120 may determine the first scale factor as the positive electrode change rate ps and determine the second scale factor as the negative electrode change rate ns.

As described above, the profile correcting unit 120 may generate a comparison full-cell profile corresponding to each pair of first scale factor and second scale factor selected from the scaling value range. Since the pair of first scale factor and second scale factor is plural, it is obvious that the comparison full-cell profile will also be generated in plural. The profile correcting unit 120 may identify the minimum value among the profile errors of the plurality of comparison full-cell profiles and then obtain information mapped to the minimum profile error from the storage unit 140.

The apparatus 100 for estimating a SOH according to the present disclosure may be connected to a display device (not shown) and output information on the SOH of a battery. Because of this, the information about the SOH of the battery may be displayed on the display device.

The apparatus 100 for estimating a SOH according to the present disclosure may be connected to an alarm device (not shown) and output information on the SOH of a battery to operate the alarm device.

The apparatus 100 for estimating a SOH according to the present disclosure may be applied to the BMS. In other words, the BMS according to the present disclosure may include the above-described apparatus 100 for estimating a SOH. In this configuration, at least some of the components of the apparatus 100 for estimating a SOH may be implemented by supplementing or adding functions of components included in a conventional BMS. For example, the profile obtaining unit 110, the profile correcting unit 120, the control unit 130 and the storage unit 140 of the apparatus 100 for estimating a SOH may be implemented as components of a BMS. Additionally, the apparatus 100 for estimating a SOH according to the present disclosure may be provided in the battery pack. That is, the battery pack according to the present disclosure may include the above-described apparatus 100 for estimating a SOH and at least one battery cell. Additionally, the battery pack may further include electrical components (relays, fuses, etc.) and a case.

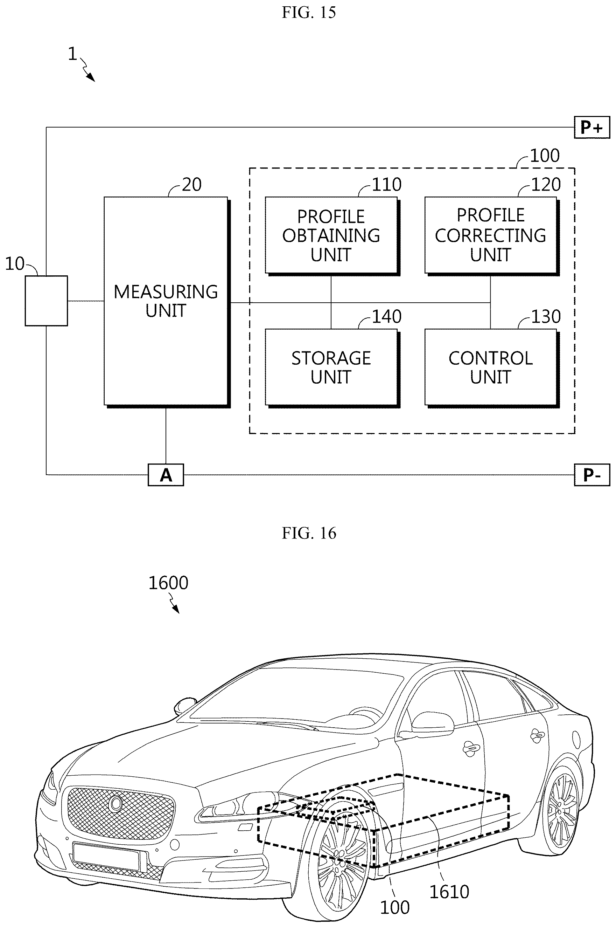

FIG. 15 is a diagram showing an exemplary configuration of the battery pack 1 including according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to the positive electrode terminal and the negative electrode terminal of the battery 10. Additionally, the measuring unit 20 may measure the voltage of the battery 10 by measuring the positive electrode potential and the negative electrode potential of the battery 10 and calculating the difference between the positive electrode potential and the negative electrode potential. Preferably, the measuring unit 20 may measure OCV of the battery 10.

In addition, the measuring unit 20 may be connected to a current measurement unit A. For example, the current measurement unit A may be an ammeter or shunt resistor that may measure the charging current and discharging current of the battery 10. The measuring unit 20 may calculate the charging amount by measuring the charging current of the battery 10 using the current measurement unit A. Additionally, the measuring unit 20 may calculate the discharge amount by measuring the discharge current of the battery 10 through the current measurement unit A.

For example, the information about the voltage and capacity of the battery 10 measured by the measuring unit 20 may be transmitted to the profile obtaining unit 110. Additionally, the profile obtaining unit 110 may directly generate an OCV profile Rocv based on the received information about the voltage and capacity.

As another example, the information about the voltage and capacity of the battery 10 measured by the measuring unit 20 may be stored in the storage unit 140. When the charging or discharging of the battery 10 is completed, the profile obtaining unit 110 may access the storage unit 140 to obtain the OCV profile Rocv.

As still another example, the measuring unit 20 may directly generate an OCV profile Rocv based on the measured information about the voltage and capacity of the battery 10. In this case, the generated OCV profile Rocv may be transmitted to the profile obtaining unit 110 and also be stored in the storage unit 140.

A charge/discharge device or load may be connected to the positive electrode terminal P+ and the negative electrode terminal P- of the battery pack 1.

FIG. 16 is a diagram schematically showing an exemplary configuration of a vehicle according to still another embodiment of the present disclosure.

Referring to FIG. 16, the battery pack 1610 according to an embodiment of the present disclosure may be included in a vehicle 1600 such as an electric vehicle (EV) or a hybrid vehicle (HV). In addition, the battery pack 1610 may drive the vehicle 1600 by supplying power to a motor through an inverter included in the vehicle 1600. Here, the battery pack 1610 may include the apparatus 100 for estimating a SOH. That is, the vehicle 1600 may include the apparatus 100 for estimating a SOH.

In this case, the apparatus 100 for estimating a SOH may be an on-board diagnostic device included in the vehicle 1600. That is, the apparatus 100 for estimating a SOH may estimate the SOH of the battery in various aspects based on the OCV profile for the battery included in the vehicle 1600. Also, the apparatus 100 for estimating a SOH may provide information about the estimated SOH to the user.

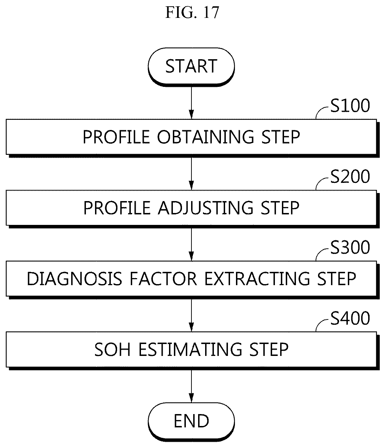

FIG. 17 is a diagram schematically showing a method for estimating a SOH according to still another embodiment of the present disclosure.

Referring to FIG. 17, the method for estimating a SOH may include a profile obtaining step (S100), a profile adjusting step (S200), a diagnosis factor extracting step (S300), and a SOH estimating step (S400).

Preferably, each step of the method for estimating a SOH may be performed by the apparatus 100 for estimating a SOH. Hereinafter, for convenience of explanation, content that overlaps with the content described above will be omitted or briefly described.

The profile obtaining step (S100) is a step of obtaining an OCV profile Rocv for a plurality of OCVs of a battery measured at different time points, and may be performed by the profile obtaining unit 110.

For example, the profile obtaining unit 110 may directly receive the OCV profile Rocv from the outside. That is, the profile obtaining unit 110 may obtain the OCV profile Rocv by receiving the OCV profile Rocv by being connected to the outside wired and/or wirelessly.

As another example, the profile obtaining unit 110 may receive battery information about the capacity and OCV of the battery. Additionally, the profile obtaining unit 110 may generate an OCV profile Rocv based on the received battery information. That is, the profile obtaining unit 110 may obtain the OCV profile Rocv by directly generating the OCV profile Rocv based on the battery information.

The profile adjusting step (S200) is a step of generating an adjusted positive electrode profile and an adjusted negative electrode profile by adjusting a preset criterion positive electrode profile and a preset criterion negative electrode profile to correspond to the OCV profile Rocv, and may be performed by the profile correcting unit 120.

For example, the profile correcting unit 120 may generate a plurality of comparison full-cell profile by shifting the criterion positive electrode profile Rp and the criterion negative electrode profile Rn or scaling the capacity thereof, and specify a comparison full-cell profile S having a minimum error with the OCV profile Rocv among the plurality of comparison full-cell profile. Also, an adjusted positive electrode profile and an adjusted negative electrode profile corresponding to the specified comparison full-cell profile S may be determined.

The diagnosis factor extracting step (S300) is a step of extracting at least one of a diagnosis factor related to the positive electrode participation finalizing point for the battery from the adjusted positive electrode profile and a diagnosis factor related to the positive electrode change rate for the battery from the criterion positive electrode profile and the adjusted positive electrode profile, and may be performed by the control unit 130.

The SOH estimating step (S400) is a step of estimating the SOH of the battery based on the extracted diagnosis factor, and may be performed by the control unit 130.

For example, the control unit 130 may estimate the positive electrode SOH ($SOH_P$) by referring to at least one of Equations 1 to 3.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

(Explanation of reference signs)

1: battery pack
10: battery
20: measuring unit
100: apparatus for estimating a SOH
110: profile obtaining unit
120: profile correcting unit
130: control unit
140: storage unit
1600: vehicle
1610: battery pack

**Claims**

1. An apparatus for estimating a SOH, comprising:

   a profile obtaining unit configured to obtain an OCV profile for a plurality of OCVs of a battery measured at different time points;
   a profile correcting unit configured to generate an adjusted positive electrode profile and an adjusted negative electrode profile by adjusting a preset criterion positive electrode profile and a preset criterion negative electrode profile to correspond to the OCV profile; and
   a control unit configured to extract at least one of a diagnosis factor related to the positive electrode participation finalizing point for the battery from the adjusted positive electrode profile and a diagnosis factor related to the positive electrode change rate for the battery from the criterion positive electrode profile and the adjusted positive electrode profile, and estimate a positive electrode SOH of the battery based on the extracted diagnosis factor.

2. The apparatus for estimating a SOH according to claim 1,
   wherein the plurality of OCVs are configured to include an OCV measured at a time point when the battery transitions from an idle state to a discharge state and an OCV measured while a condition that a discharge current of the battery is equal to or less than a preset threshold current is maintained during a preset criterion time or more.

3. The apparatus for estimating a SOH according to claim 2,
   wherein the plurality of OCVs are configured to include a plurality of OCVs measured within a preset criterion period.

4. The apparatus for estimating a SOH according to claim 3,
   wherein the criterion period is set based on a preset target period, a period required to measure a preset number of OCVs, a period required to reduce the SOH of the battery by a preset criterion SOH, or a combination thereof.

5. The apparatus for estimating a SOH according to claim 1,
   wherein the profile correcting unit is configured to generate a comparison full-cell profile based on the criterion positive electrode profile and the criterion negative electrode profile, and generate the adjusted positive electrode profile and the adjusted negative electrode profile by adjusting the criterion positive electrode profile and the criterion negative electrode profile until the generated comparison full-cell profile corresponds to the OCV profile.

6. The apparatus for estimating a SOH according to claim 5,
   wherein the profile correcting unit is configured to determine a target capacity range corresponding to the OCV profile and compare the comparison full-cell profile and the OCV profile in the target capacity range.

7. The apparatus for estimating a SOH according to claim 1,
   wherein the control unit is configured to estimate the positive electrode SOH of the battery by comparing the value of the diagnosis factor with a criterion value preset for the diagnosis factor.

8. The apparatus for estimating a SOH according to claim 1,
   wherein the control unit is configured to adjust a usage condition for the battery based on the estimated positive electrode SOH.

9. A battery pack, comprising the apparatus for estimating a SOH according to any one of claims 1 to 8.

10. A vehicle, comprising the apparatus for estimating a SOH according to any one of claims 1 to 8.

11. A server, comprising the apparatus for estimating a SOH according to any one of claims 1 to 8.

12. A method for estimating a SOH, comprising:

    a profile obtaining step of obtaining an OCV profile for a plurality of OCVs of a battery measured at different time points;
    a profile adjusting step of generating an adjusted

**EP 4 675 293 A1**

positive electrode profile and an adjusted negative electrode profile by adjusting a preset criterion positive electrode profile and a preset criterion negative electrode profile to correspond to the OCV profile;

a diagnosis factor extracting step of extracting at least one of a diagnosis factor related to the positive electrode participation finalizing point for the battery from the adjusted positive electrode profile and a diagnosis factor related to the positive electrode change rate for the battery from the criterion positive electrode profile and the adjusted positive electrode profile; and

a SOH estimating step of estimating a positive electrode SOH of the battery based on the extracted diagnosis factor.

FIG. 1

FIG. 2

EP 4 675 293 A1

FIG. 3

22

FIG. 4

FIG. 5

FIG. 6

FIG. 7

FIG. 8

FIG. 9

FIG. 10

FIG. 11

FIG. 12

FIG. 13

FIG. 14

FIG. 15

FIG. 16

FIG. 17

START

PROFILE OBTAINING STEP — S100

PROFILE ADJUSTING STEP — S200

DIAGNOSIS FACTOR EXTRACTING STEP — S300

SOH ESTIMATING STEP — S400

END

# EP 4 675 293 A1

<table>
<tr><td colspan="2" align="center"><strong>INTERNATIONAL SEARCH REPORT</strong></td><td>International application No.<br><br><strong>PCT/KR2024/012804</strong></td></tr>
</table>

| A. | CLASSIFICATION OF SUBJECT MATTER |
|---|---|

**G01R 31/392**(2019.01)i; **G01R 31/396**(2019.01)i; **G01R 31/367**(2019.01)i; **G01R 31/385**(2019.01)i; **G01R 31/382**(2019.01)i; **G01R 19/165**(2006.01)i; **B60L 58/16**(2019.01)i

According to International Patent Classification (IPC) or to both national classification and IPC

| B. | FIELDS SEARCHED |
|---|---|

Minimum documentation searched (classification system followed by classification symbols)

G01R 31/392(2019.01); B60L 3/00(2006.01); B60L 58/12(2019.01); B60L 58/16(2019.01); G01R 19/00(2006.01); G01R 31/36(2006.01); H01M 10/44(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 노화도(State of Health, SOH), 양극(positive electrode), 음극 (negative electrode), 기준 프로파일(reference profile), 개방회로전압(open circuit voltage, OCV), 보정(correction)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | KR 10-2493232 B1 (LG ENERGY SOLUTION, LTD.) 27 January 2023 (2023-01-27)<br>See paragraphs [0054]-[0057] and [0102]-[0104], claim 1 and figure 5. | 1-12 |
| A | KR 10-2022-0094042 A (LG ENERGY SOLUTION, LTD.) 05 July 2022 (2022-07-05)<br>See paragraphs [0041] and [0104] and claims 1-5. | 1-12 |
| A | KR 10-2023-0065406 A (MISUM SYSTECH CO., LTD.) 12 May 2023 (2023-05-12)<br>See claims 1 and 4 and figure 2. | 1-12 |
| A | KR 10-2022-0017560 A (HYUNDAI MOTOR COMPANY et al.) 14 February 2022 (2022-02-14)<br>See paragraphs [0122]-[0123], claims 1-2 and 11 and figure 6. | 1-12 |
| A | US 2018-0011143 A1 (FRAUNHOFER-GESELLSCHAFT ZUR FOERDERUNG DER ANGEWANDTEN FORSCHUNG E.V.) 11 January 2018 (2018-01-11)<br>See paragraphs [0124]-[0126] and claims 51-56. | 1-12 |

☐ Further documents are listed in the continuation of Box C. ☑ See patent family annex.

| | | | |
|---|---|---|---|
| \* | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **12 December 2024** | **12 December 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/012804**

| Patent document cited in search report | | | Publication date (day/month/year) | Patent family member(s) | | | Publication date (day/month/year) |
|---|---|---|---|---|---|---|---|
| KR | 10-2493232 | B1 | 27 January 2023 | CN | 113646651 | A | 12 November 2021 |
| | | | | CN | 113646651 | B | 14 May 2024 |
| | | | | EP | 3839537 | A1 | 23 June 2021 |
| | | | | EP | 3839537 | B1 | 07 February 2024 |
| | | | | ES | 2976734 | T3 | 07 August 2024 |
| | | | | HU | E065975 | T2 | 28 June 2024 |
| | | | | JP | 2022-503496 | A | 12 January 2022 |
| | | | | JP | 7169497 | B2 | 11 November 2022 |
| | | | | PL | 3839537 | T3 | 27 May 2024 |
| | | | | US | 2021-0318388 | A1 | 14 October 2021 |
| | | | | WO | 2020-189915 | A1 | 24 September 2020 |
| KR | 10-2022-0094042 | A | 05 July 2022 | CN | 115398256 | A | 25 November 2022 |
| | | | | EP | 4119963 | A1 | 18 January 2023 |
| | | | | JP | 2023-515831 | A | 14 April 2023 |
| | | | | JP | 7395808 | B2 | 12 December 2023 |
| | | | | US | 12085623 | B2 | 10 September 2024 |
| | | | | US | 2023-0160970 | A1 | 25 May 2023 |
| | | | | WO | 2022-145777 | A1 | 07 July 2022 |
| KR | 10-2023-0065406 | A | 12 May 2023 | None | | | |
| KR | 10-2022-0017560 | A | 14 February 2022 | None | | | |
| US | 2018-0011143 | A1 | 11 January 2018 | CN | 107690725 | A | 13 February 2018 |
| | | | | CN | 107690725 | B | 26 June 2020 |
| | | | | DE | 102015205228 | A1 | 29 September 2016 |
| | | | | DK | 3275040 | T3 | 12 August 2019 |
| | | | | EP | 3275040 | A1 | 31 January 2018 |
| | | | | EP | 3275040 | B1 | 08 May 2019 |
| | | | | HU | E045440 | T2 | 30 December 2019 |
| | | | | JP | 2018-511149 | A | 19 April 2018 |
| | | | | JP | 6577047 | B2 | 18 September 2019 |
| | | | | KR | 10-2017-0128596 | A | 22 November 2017 |
| | | | | KR | 10-2046047 | B1 | 18 November 2019 |
| | | | | PL | 3275040 | T3 | 29 November 2019 |
| | | | | US | 10393817 | B2 | 27 August 2019 |
| | | | | WO | 2016-151058 | A1 | 29 September 2016 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230115868